# EUROPÄISCHE PATENTSCHRIFT

(11) **EP 1 301 948 B1**
(45) Veröffentlichungstag und Bekanntmachung des Hinweises auf die Patenterteilung: **26.05.2004**
(21) Anmeldenummer: 01962822.1
(22) Anmeldetag: 03.07.2001
(51) Int. Cl.: H01L 37/02

(54) **HALBLEITERBAUELEMENT MIT EINER PIEZO- ODER PYROELEKTRISCHEN SCHICHT UND DESSEN HERSTELLUNGSVERFAHREN**
SEMICONDUCTOR ELEMENT COMPRISING A SEQUENCE OF LAYERS FOR CONVERTING ACOUSTIC OR THERMAL SIGNALS AND ELECTRICAL VOLTAGE CHANGES INTO EACH OTHER AND METHOD FOR PRODUCING THE SAME
COMPOSANT SEMI-CONDUCTEUR POURVU D'UNE SUCCESSION DE COUCHES POUR LA CONVERSION MUTUELLE DE SIGNAUX ACOUSTIQUES OU THERMIQUES ET DE VARIATIONS DE TENSION ELECTRIQUES, AINSI QUE PROCEDE POUR SA PRODUCTION

(30) Priorität: 20.07.2000 DE 10035423
(43) Veröffentlichungstag der Anmeldung: 16.04.2003
(73) Patentinhaber: Infineon Technologies AG, 81669 München (DE)
(72) Erfinder: AIGNER, Robert, 81675 Muenchen (DE); ELBRECHT, Lueder, 80805 Muenchen (DE); HERZOG, Thomas, Rainer, 85635 Hoehenkirchen-Siegertsbrunn (DE); MARKSTEINER, Stephan, 85579 Neubiberg (DE); NESSLER, Winfried, 81739 Muenchen (DE)
(74) Vertreter: Ginzel, Christian
(86) Internationale Anmeldenummer: PCT/EP2001/007604
(87) Internationale Veröffentlichungsnummer: WO 2002/009131

(56) Entgegenhaltungen:
- EP-A- 0 963 040
- EP-A- 1 124 328
- LUTSKY J J ET AL: "A sealed cavity TFR process for RF bandpass filters" 1996 INTERNATIONAL ELECTRON DEVICES MEETING, SAN FRANCISCO, CA, USA, 8. - 11. Dezember 1996, Seiten 95-98, XP000753738 ISBN: 0-7803-3394-2
- HIBOUX S ET AL: "Piezoelectric and dielectric properties of sputter deposited (111), (100) and random-textured Pb(ZrxTi1-x)O3 (PZT) thin films" FERROELECTRICS, Bd. 224, Nr. 1-4, 1999, Seiten 315-322, XP000978337 ISSN: 0015-0193

## Beschreibung

Die Erfindung betrifft ein Halbleiterbauelement mit einer Schichtenfolge zum ineinander Umwandeln von akustischen oder thermischen Signalen und elektrischen Spannungsänderungen sowie ein Verfahren zu dessen Herstellung.

Ein solches Halbleiterbauelement weist typischerweise eine untere Elektrode, eine obere Elektrode und eine dazwischen angeordnete Schicht auf, die für den Fall, daß akustische Schwingungen erzeugt oder nachgewiesen werden, piezoelektrisch ist, und für den Fall, daß thermische Signale erzeugt oder nachgewiesen werden, pyroelektrisch ist. In beiden Fällen wird eine ausgeprägte Textur der Kristallstruktur der Schicht angestrebt, um einen möglichst hohen piezoelektrischen bzw. pyroelektrischen Koppelkoeffizienten zu erzielen. Je größer dieser Koppelkoeffizient ist, um so ausgeprägter sind die meßbaren elektrischen Spannungsänderungen bei einem vorgegebenen akustischen bzw. thermischen Signal.

Ein Halbleiterbauelement, bei dem durch Anlegen elektrischer Spannungsänderung akustische Schwingungen durch den piezoelektrischen Effekt erzeugt werden, ist z.B. in Dubois et al, "Properties of aluminum nitride thin films for piezoelectric transducers and microwave filter applications", Appl. Phys. Lett. Vol. 74, No.20, S.3032-3034 beschrieben. Eine Schichtenfolge, durch die die akustischen Schwingungen erzeugt werden, besteht aus einer unteren und oberen Elektrode und eine dazwischen angeordnete piezoelektrische Schicht aus AlN. Zur Verbesserung der Textur wird vorgeschlagen, die untere Elektrode aus Platin zu erzeugen. Durch Aufwachsen der piezoelektrischen Schicht auf Platin wird eine bessere Textur der Schicht erzielt, da Platin und AlN ähnliche Kristalleigenschaften aufweisen.

Der Erfindung liegt die Aufgabe zugrunde, ein Halbleiterbauelement mit einer Schichtenfolge zum ineinander Umwandeln von akustischen oder thermischen Signalen und elektrischen Spannungsänderungen anzugeben, deren piezoelektrische oder pyroelektrische Schicht im Vergleich zum Stand der Technik eine verbesserte Textur aufweist. Ferner soll ein Verfahren zur Herstellung eines solchen Halbleiterbauelements angegeben werden.

Aus dem Aufsatz von J. J. Lutsky et al., IEDM 1996, Seiten 95-98 ist ein Halbleiterbauelement mit einer Schichtenfolge bekannt, die über einem versiegelten Hohlraum angeordnet ist und eine untere Elektrode aus Al-Si/Ti, eine Hilfsschicht aus PECVD SiNₓ, eine piezoelektrische Schicht aus AlN und eine obere Elektrode aus Ti/Al-Si aufweist. Die PECVD-SiNₓ Schicht dient als 'seed layer' für die piezoelektrische Schicht.

Die Aufgabe wird gelöst durch ein Halbleiterbauelement nach Anspruch 1 mit einer Schichtenfolge zum ineinander Umwandeln von akustischen oder thermischen Signalen und elektrischen Spannungsänderungen, wobei die Schichtenfolge eine untere Elektrode, eine obere Elektrode und eine dazwischen angeordnete Schicht, die piezoelektrisch oder pyroelektrisch ist, aufweist, wobei zwischen der unteren Elektrode und der Schicht eine Hilfsschicht angeordnet ist, die einem homogen orientierten Aufwachsen der Schicht beim Herstellungsverfahren dient und im wesentlichen aus amorphem Silizium oder amorphem Siliziumoxid besteht.

Ferner wird die Aufgabe gelöst durch ein Verfahren zur Herstellung eines Halbleiterbauelements nach Anspruch 7 mit einer Schichtenfolge zum ineinander Umwandeln von akustischen oder thermischen Signalen und elektrischen Spannungsänderungen, bei dem als Teile der Schichtenfolge eine untere Elektrode, darüber eine Hilfsschicht, darüber eine Schicht, die piezoelektrisch oder pyroelektrisch ist, und darüber eine obere Elektrode erzeugt werden, wobei die Hilfsschicht im wesentlichen aus amorphem Silizium oder amorphen Siliziumoxid besteht und derart erzeugt wird, daß sie ein homogen orientiertes Aufwachsen der Schicht fördert.

Es hat sich gezeigt, daß aufgrund der Hilfsschicht, insbesondere aus im wesentlichen amorphem Silizium, amorphem Siliziumoxid oder amorphem Siliziumnitrid, eine wesentlich bessere Textur der piezoelektrischen oder pyroelektrischen Schicht erzielt wird. Der zugrundeliegende physikalische Effekt besteht darin, daß die erfindungsgemäße Hilfsschicht eine chemisch streng definierte Oberfläche bildet, so daß auf sämtlichen Bereichen der Hilfsschicht das Wachstum der piezoelektrischen oder pyroelektrischen Schicht mit dem selben Element beginnt. Durch diese Oberfläche wird sichergestellt, daß sich die Kristallite der Schicht in definierte Polarisation anlagern.

Die Oberfläche der Hilfsschicht kann passiviert sein. Beispielsweise kann die Hilfsschicht an der Oberfläche in einer Dicke von ca. 1 bis 2 nm oxidiert sein. Alternativ kann die Hilfsschicht beispielsweise nitridiert sein.

Aufgrund der geringen elektrischen Leitfähigkeit der Hilfsschicht ist es nicht erforderlich, die Hilfsschicht zu strukturieren. Die Hilfsschicht kann als ganzflächige Schicht auf Halbleiterscheiben verbleiben, ohne daß es zu Kurzschlüssen zwischen den Elektroden kommt.

Die Hilfsschicht wirkt ferner als Diffusionsbarriere für Verunreinigungen, die aus Schichten unterhalb der unteren Elektrode während der Abscheidung der Schicht herausdiffundieren. Diese Eigenschaft der Hilfsschicht ist besonders vorteilhaft, da es sich gezeigt hat, daß bereits kleinste Verunreinigungen durch Sauerstoff oder Wasserstoff das Wachstum der piezo- bzw. pyroelektrischen Schicht empfindlich stören.

Das Herstellungsverfahren eines erfindungsgemäßen Halbleiterbauelements ist besonders einfach durchführbar, da insbesondere eine Abscheidung von amorphem Silizium oder amorphem Siliziumoxid kompatibel zur CMOS-Fertigung ist.

Die Schicht besteht beispielsweise im wesentlichen aus AlN. Es sind jedoch auch andere piezoelektrische oder pyroelektrische Materialien geeignet.

Bei Halbleiterbauelementen, durch die akustische Schwingungen erzeugt oder nachgewiesen werden, bestimmt die Dicke der Schicht die Frequenz der akustischen Schwingungen. Ist das Halbleiterbauelement beispielsweise ein Resonator bei 2 GHz, so beträgt die Dicke der Schicht etwa 2 µm.

Die untere Elektrode und/oder die obere Elektrode bestehen beispielsweise im wesentlichen oder teilweise aus Wolfram, Molybdän, Platin oder einer Aluminiumlegierung, oder aus einer Kombination dieser Metalle.

Es hat sich gezeigt, daß neben der chemischen Stabilität der Oberfläche, auf der die Schicht abgeschieden wird, auch die Rauheit der Oberfläche die Qualität der Textur der Schicht wesentlich beeinflußt. Das Kristallwachstum erfolgt lokal senkrecht zur Oberfläche. Auf rauhen Oberflächen wachsen Kristallite zunächst mit großen Richtungsschwankungen, bis sie sich gegenseitig im Wachstum blockieren und nur die im wesentlichen senkrecht gerichteten Kristallite weiterhin wachstumsfähig bleiben. Die Dicke jenes Teils der Schicht, in dem dieser Selektionsprozeß erfolgt, ist stark von der Rauheit der Oberfläche abhängig. Da dieser Anteil der Schicht schlechte piezo- bzw. pyroelektrische Eigenschaften aufweist, verschlechtert sich der Koppelkoeffizient der Schicht auf einer rauhen Oberfläche deutlich. Um die Rauheit der Oberfläche zu reduzieren, ist es vorteilhaft, die untere Elektrode zu erzeugen, indem ein geeignetes Material abgeschieden und anschließend durch chemisch-mechanisches Polieren (CMP) geglättet wird. Dieser Prozeßschritt ist besonders vorteilhaft, wenn die untere Elektrode durch Abscheiden von Wolfram in einem CVD-Verfahren erzeugt wird, da eine solche Elektrode ohne Glätten eine besonders hohe Rauheit aufweist. Da das chemisch-mechanische Polieren nur zum Glätten verwendet wird, genügt bereits ein kurzer CMP-Schritt, bei dem lediglich 10 bis 100 nm abgetragen werden.

Die Hilfsschicht kann durch Sputtern aufgebracht werden. Dieser Schritt kann insitu oder exsitu durchgeführt werden. Im ersten Fall wird die Schicht gleich nach dem Sputtern aufgebracht. Im zweiten Fall wird die Hilfsschicht vor dem Aufbringen der Schicht der Atmosphäre ausgesetzt.

Das Halbleiterbauelement kann beispielsweise als Bulk-Acoustic-Wave Resonator oder als Filter mit einem solchen Bulk-Acoustic-Wave Resonator ausgestaltet sein. Dazu ist die Schichtenfolge auf einem Träger angeordnet, der so ausgestaltet ist, daß er durch die Schichtenfolge erzeugte akustische Schwingungen reflektiert. Beispielsweise besteht der Träger aus einer Anzahl von übereinander angeordneten Schichten, die alternierend eine hohe und eine niedrige akustische Impedanz aufweisen.

Die Dicke der Hilfsschicht ist vorzugsweise so gering wie möglich, damit Reflexionsbedingungen des Träger möglichst gut erfüllt werden. Beispielsweise beträgt die Dicke der Hilfsschicht zwischen 5 nm und 50 nm.

Das Halbleiterbauelement kann auch als Oberflächenwellen-Resonator oder Dünnschicht-Resonator ausgestaltet sein.

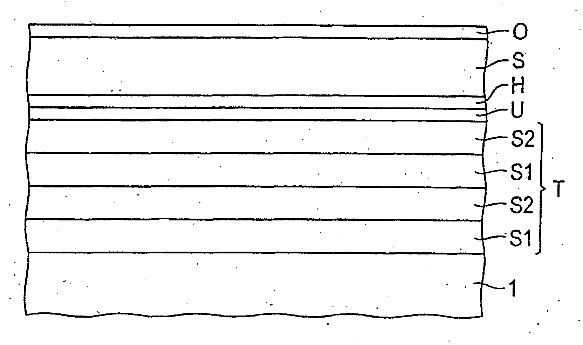

Im folgenden wird ein Ausführungsbeispiel der Erfindung anhand der Figur näher erläutert.

Die Figur zeigt einen Querschnitt durch einen Bulk-Acoustic-Wave-Resonator mit einer Schichtenfolge bestehend aus einer unteren Elektrode, einer Hilfsschicht, einer Schicht und einer oberen Elektrode und aus einem Träger.

Im Ausführungsbeispiel wird ausgehend von einem Substrat 1 aus Silizium ein Träger T erzeugt, indem eine Folge von Schichten S1, S2 abgeschieden wird, die abwechselnd eine hohe akustische Impedanz und eine niedrige akustische Impedanz aufweisen. Die Schichten S1 mit der hohen akustischen Impedanz bestehen aus Wolfram und sind ca. 850nm dick. Die Schichten S2 mit der niedrigen akustischen Impedanz bestehen aus SiO₂ und sind ca. 750nm dick.

Auf dem Träger T wird eine Schichtenfolge erzeugt. Dazu wird zunächst zur Bildung einer unteren Elektrode U Wolfram in einer Dicke von ca. 400nm abgeschieden. Anschließend wird die untere Elektrode U durch chemisch-mechanisches Polieren geglättet, wobei Wolfram bis zu einer Dicke von ca. 60nm abgetragen wird. Auf der unteren Elektrode U wird eine ca. 20nm dicke Hilfsschicht H erzeugt, indem amorphes Silizium gesputtert wird. Ohne das Substrat 1 zu belüften, wird anschließend eine piezoelektrische Schicht S erzeugt, indem AlN in einer Dicke von ca. 2µm abgeschieden wird. Darüber wird zur Erzeugung einer oberen Elektrode O Aluminium in einer Dicke von ca. 400nm abgeschieden.

Das erzeugte Bauelement ist ein Bulk-Acoustic-Wave-Resonator. Der Träger T wirkt als Bragg-Reflektor, der akustische Wellen, die durch die Schichtenfolge erzeugt werden, reflektiert. Die Dicken der Schichten S1, S2 sind so ausgelegt, daß sie bei der Betriebsfrequenz des Bulk-Acoustic-Wave-Resonators ¼ der akustischen wellenlänge im jeweiligen Material entsprechen.

### Bezugszeichenliste

- 1: Substrat
- H1, H2: Hilfsschicht
- O,U: Elektrode
- S: Schicht
- S1, S2: Schichten des Trägers
- T: Träger5

## Patentansprüche

1. Halbleiterbauelement mit einer Schichtenfolge zum ineinander Umwandeln von akustischen oder thermischen Signalen und elektrischen Spannungsänderungen,
- wobei die Schichtenfolge eine untere Elektrode (U), eine obere Elektrode (O) und eine dazwischen angeordnete Schicht (S), die piezoelektrisch oder pyroelektrisch ist, aufweist,
**dadurch gekennzeichnet, daß**
- zwischen der unteren Elektrode (U) und der Schicht (S) eine im wesentlichen aus amorphem Silizium oder amorphem Siliziumoxid bestehende Hilfsschicht (H) angeordnet ist, die einem homogen orientierten Aufwachsen der Schicht (S) beim Herstellungsverfahren dient.

2. Halbleiterbauelement nach Anspruch 1,
bei dem die Schicht (S) im wesentlichen aus AlN besteht.

3. Halbleiterbauelement nach einem der Ansprüche 1 oder 2,
bei dem die untere Elektrode (U) und die obere Elektrode (O) im wesentlichen aus Wolfram, Molybdän, Platin, einer Aluminiumlegierung oder einer Kombination dieser Metalle bestehen.

4. Halbleiterbauelement nach einem der Ansprüche 1 bis 3,
bei dem die Dicke der Hilfsschicht (H) zwischen 5nm und 50nm beträgt.

5. Halbleiterbauelement nach einem der Ansprüche 1 bis 4,
das als Bulk-Acoustic-Wave Resonator oder als Filter ausgestaltet ist, wobei die Schichtenfolge auf einem Träger (T) angeordnet ist, der so ausgestaltet ist, daß er durch die Schichtenfolge erzeugte akustische Schwingungen reflektiert.

6. Halbleiterbauelement nach einem der Ansprüche 2 bis 5,
bei dem die untere Elektrode (U) an einer Oberfläche, die an die Hilfsschicht (H) angrenzt, poliert ist.

7. Verfahren zur Herstellung eines Halbleiterbauelements mit einer Schichtenfolge zum ineinander Umwandeln von akustischen oder thermischen Signalen und elektrischen Spannungsänderungen,
bei dem als Teile der Schichtenfolge eine untere Elektrode (U), darüber eine Schicht (S), die piezoelektrisch oder pyroelektrisch ist, und darüber eine obere Elektrode (O) erzeugt werden,
**dadurch gekennzeichnet, daß**
vor Erzeugung der Schicht (S) über der unteren Elektrode (U) eine im wesentlichen aus amorphem Silizium oder amorphem Siliziumoxid bestehende Hilfsschicht (H) derart erzeugt wird, daß sie ein homogen orientiertes Aufwachsen der Schicht (S) fördert.

8. Verfahren nach Anspruch 7,
bei dem die Schicht (S) im wesentlichen aus AlN erzeugt wird.

9. Verfahren nach einem der Ansprüche 7 oder 8,
bei dem die untere Elektrode (U) und die obere Elektrode (O) im wesentlichen aus Wolfram, Molybdän, Platin, einer Aluminiumlegierung oder einer Kombination dieser Metalle erzeugt werden.

10. Verfahren nach einem der Ansprüche 7 bis 9,
bei dem die Hilfsschicht (H) in einer Dicke zwischen 5nm und 50nm aufgebracht wird.

11. Verfahren nach einem der Ansprüche 7 bis 10,
bei dem die untere Elektrode (U) erzeugt wird, indem Wolfram durch ein CVD-Verfahren abgeschieden und anschließend durch chemisch-mechanisches Polieren geglättet wird.

12. Verfahren nach einem der Ansprüche 7 bis 11,
bei dem das Halbleiterbauelement als Bulk-Acoustic-Wave Resonator oder als Filter erzeugt wird, wobei die Schichtenfolge auf einem Träger (T) erzeugt wird, der so erzeugt wird, daß er durch die Schichtenfolge erzeugte akustische Schwingungen reflektiert.

## Claims

1. Semiconductor component having a layer sequence for conversion of acoustic or thermal signals and electrical voltage changes to one another
- in which the layer sequence has a lower electrode (U), an upper electrode (O) and a layer (S) which is arranged between them and is piezoelectrical or pyroelectrical,
**characterized in that**
- an auxiliary layer (H) is arranged between the lower electrode (U) and the layer (S), is composed essentially of amorphous silicon or amorphous silicon oxide and is used for homogeneously oriented growth of the layer (S) during the production process.

2. Semiconductor component according to Claim 1,
in which the layer (S) is composed essentially of A1N.

3. Semiconductor component according to one of Claims 1 or 2,
in which the lower electrode (U) and the upper electrode (O) are composed essentially of tungsten, molybdenum, platinum, an aluminium alloy or a combination of these metals.

4. The semiconductor component according to one of Claims 1 to 3,
in which the thickness of the auxiliary layer (H) is between 5 nm and 50 nm.

5. Semiconductor component according to one of Claims 1 to 4, which is in the form of a bulk acoustic wave resonator or of a filter, in which the layer sequence is arranged on a mount (T) which is designed such that it reflects acoustic oscillations produced by the layer sequence.

6. Semiconductor component according to one of Claims 2 to 5, in which the lower electrode (U) is polished on a surface which is adjacent to the auxiliary layer (H).

7. Process for producing a semiconductor component having a layer sequence for conversion of acoustic or thermal signals and electrical voltage changes for one another
in which a lower electrode (U), a layer (S) above it which is piezoelectrical or pyroelectrical, and an upper electrode (O) above the layer (S) are produced as parts of the layer sequence,
**characterized in that**,
before the layer (S) is produced, an auxiliary layer (H), which is composed essentially of amorphous silicon or amorphous silicon oxide, is produced above the lower electrode (U), such that this auxiliary layer (H) promotes homogeneously oriented growth of the layer (S).

8. Process according to Claim 7,
in which the layer (S) is produced essentially from AlN.

9. Process according to one of Claims 7 or 8,
in which the lower electrode (U) and the upper electrode (O) are composed essentially of tungsten, molybdenum, platinum, an aluminium alloy or a combination of these metals.

10. Process according to one of Claims 7 to 9,
in which the thickness of the auxiliary layer (H) is between 5 nm and 50 nm.

11. Process according to one of Claims 7 to 10,
in which the lower electrode (U) is produced by depositing tungsten by means of a CVD process, and then smoothing by means of chemical/mechanical polishing.

12. Process according to one of Claims 7 to 11,
in which the semiconductor component is produced as a bulk acoustic wave resonator or as a filter,
in which the layer sequence is arranged on a mount (T) which is designed such that it reflects acoustic oscillations produced by the layer sequence.

## Revendications

1. Composant à semi-conducteur ayant une succession de couches pour transformer les uns dans les autres des signaux acoustiques ou thermiques et des variations de tension électrique,
- la succession de couches comprenant une électrode (U) inférieure, une électrode (O) supérieure et une couche (S) piézoélectrique ou pyroélectrique interposée entre elles,
**caractérisé en ce que**
- il est interposé entre l'électrode (U) inférieure et la couche (S) une couche (H) auxiliaire essentiellement en silicium amorphe ou en oxyde de silicium amorphe qui sert à obtenir une croissance orientée de manière homogène de la couche (S) lors du procédé de production.

2. Composant à semi-conducteur suivant la revendication 1, dans lequel la couche (S) est essentiellement en AlN;

3. Composant à semi-conducteur suivant l'une des revendications 1 ou 2, dans lequel l'électrode (U) inférieure et l'électrode (O) supérieure sont essentiellement en tungstène, en molybdène, en platine, en un alliage d'aluminium ou en une combinaison de ces métaux.

4. Composant à semi-conducteur suivant l'une des revendications 1 à 3, dans lequel l'épaisseur de la couche (H) auxiliaire est comprise entre 5 nm et 50 nm.

5. Composant à semi-conducteur suivant l'une des revendications 1 à 4, qui est conformé en résonateur d'ondes acoustiques Bulk ou en filtre, la succession de couches étant disposée sur un support (T) qui est conformé de manière à réfléchir les vibrations acoustiques produites par la succession de couches.

6. Composant à semi-conducteur suivant l'une des revendications 2 à 5, dans lequel l'électrode (U) inférieure est polie sur une surface qui est adjacente à la couche (H) auxiliaire.

7. Procédé de production d'un composant à semi-conducteur ayant une succession de couches pour la transformation les uns dans les autres de signaux acoustiques ou thermiques et de variations de tension électrique,
dans lequel, comme partie de la succession de couches, on produit une électrode (U) inférieure, au-dessus une couche (S), qui est piézoélectrique ou pyroélectrique, et au-dessus une électrode (O) supérieure,
**caractérisé en ce qu'**avant la production de la couche (S), on produit sur l'électrode (U) inférieure une couche (H) auxiliaire essentiellement en silicium amorphe ou en oxyde de silicium amorphe, de façon à ce qu'elle favorise une croissance orientée de manière homogène de la couche (S).

8. Procédé suivant la revendication 7, dans lequel on produit la couche (S) essentiellement en AIN.

9. Procédé suivant l'une des revendications 7 ou 8, dans lequel on produit l'électrode (U) inférieure et l'électrode (O) supérieure essentiellement en tungstène, en molybdène, en platine, en un alliage d'aluminium ou en une combinaison de ces métaux.

10. Procédé suivant l'une des revendications 7 à 9, dans lequel on dépose la couche (H) auxiliaire en une épaisseur comprise entre 5 nm et 50 nm.

11. Procédé suivant l'une des revendications 7 à 10, dans lequel on produit l'électrode (U) inférieure en déposant du tungstène par un procédé CVD et en la lissant ensuite par un polissage chémiomécanique.

12. Procédé suivant l'une des revendications 7 à 11, dans lequel on produit un composant à semi-conducteur sous la forme d'un résonateur d'ondes acoustiques Bulk ou sous la forme d'un filtre, en produisant la succession de couches sur un support (T) qui est produit de manière à réfléchir les vibrations acoustiques produites par la succession de couches.
